## Europäisches Patentamt
## European Patent Office
## Office européen des brevets

(19)

(11) Veröffentlichungsnummer: **0 017 802**
**B1**

(12)
# EUROPÄISCHE PATENTSCHRIFT

(45) Veröffentlichungstag der Patentschrift:
28.07.82

(51) Int. Cl.³: **H 03 K 3/023**

(21) Anmeldenummer: **80101551.2**

(22) Anmeldetag: **24.03.80**

(54) Monolithisch integrierbarer Rechteckimpulsgenerator.

(30) Priorität: **29.03.79 DE 2912492**

(43) Veröffentlichungstag der Anmeldung:
**29.10.80 Patentblatt 80/22**

(45) Bekanntmachung des Hinweises auf die Patenterteilung:
**28.07.82 Patentblatt 82/30**

(84) Benannte Vertragsstaaten:
**FR GB IT**

(56) Entgegenhaltungen:
**DE-A-2 712 369**
**DE-B-1 921 035**
**US-A-3 694 772**

**U. TIETZE et al. ,,Halbleiter-Schaltungstechnik'',
4. Auflage 1978, SPRINGER-VERLAG, Berlin, Heidelberg, New York, Seiten 443 bis 444**

**HELWETT PACKARD JOURNAL, Band 30, Nr. 5,
Mai 1979, W. HÜTTEMANN et al. ''A Precision
Programmable Pulse Generator'', Seiten 3 bis 10**

(73) Patentinhaber: **SIEMENS AKTIENGESELLSCHAFT**
**Berlin und München, Postfach 22 02 61,**
**D-8000 München 22 (DE)**

(72) Erfinder: **Mündel, Gerhard, Dipl.-Ing.,**
**Pienzenauerstrasse 14, D-8019 Glonn (DE)**

## Monolithisch integrierbarer Rechteckimpulsgenerator

Die Erfindung betrifft einen monolithisch integrierbaren Rechteckimpulsgenerator mit einem durch zwei — einander entgegengesetzt wirkenden — Konstantstromquellen beaufschlagten Kondensator, dessen einer Anschluss mit den beiden Konstantstromquellen und ausserdem mit dem nichtinvertierenden Eingang eines als Schmitt-Trigger geschalteten Operationsverstärkers verbunden ist und dessen anderen Anschluss am Bezugspotential (Masse) liegt.

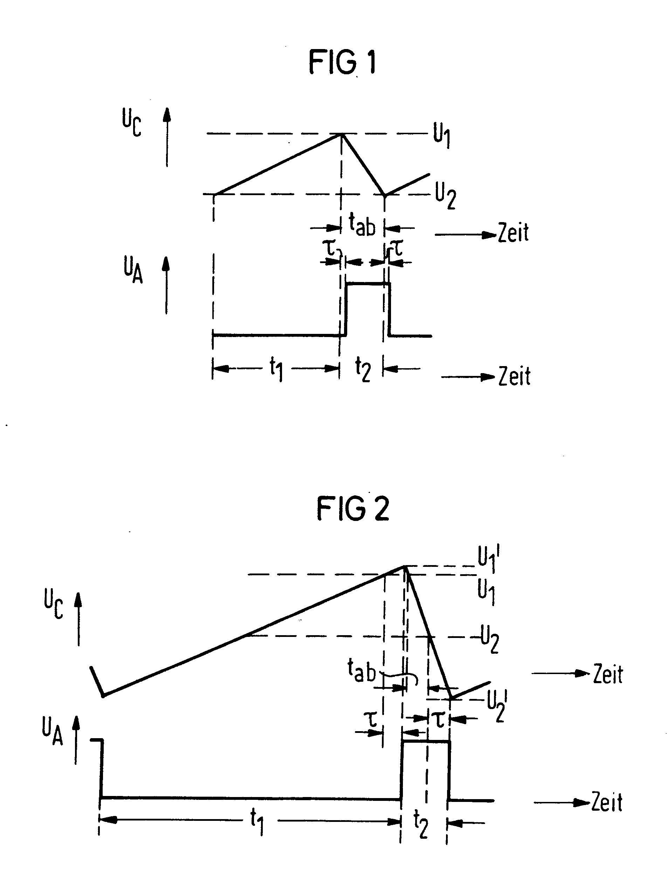

Ein ähnlicher Rechteckimpulsgenerator ist in dem Buch „Halbleiter-Schaltungstechnik" von Tietze-Schenk (Ausgabe 1978) auf S. 443 beschrieben. Erfahrungsgemäss hat jedoch dieser bekannte Rechteckimpulsgenerator den Nachteil, dass die von ihm gelieferten Rechteckimpulse von dem an sich zu erwartenden Ergebnis umso störender abweichen, je höher die Betriebsfrequenz des Generators ist, was insbesondere bei frei wählbarem Tastverhältnis in bezug auf das Frequenz- und Tastverhältnis festzustellen ist. Wie anhand der Fig. 1 dann gezeigt wird, ist die Ursache für diese unerwünschten Abweichungen vor allem die Verzögerung zwischen der Feststellung eines für das Verhalten der Anlage kritischen Schwellwertes und der Reaktion der Anlage.

Um die diesem Problem zu begegnen, kann man mit einem Mehraufwand an Schaltung, z.B. durch Anwendung einer sog. ungesättigten Schaltungstechnik beim Aufbau des Generators, sowie dem hierdurch bedingten höheren Stromaufwand, die schädlichen Signallaufzeiten verkleinern. Es wäre deshalb erwünscht, wenn man beide Nachteile reduzieren und dennoch den Nachteil der bekannten Rechteckimpulsgeneratoren der oben definierten Art vermeiden könnte. Mit der Lösung dieser Aufgabe befasst sich die vorliegende Erfindung.

Zu diesem Zweck wird gemäss der Erfindung der eingangs definierte Rechteckimpulsgenerator derart ausgestaltet, dass der durch die beiden Konstantstromquellen beaufschlagte Anschluss des Kondensators mit einer weiteren — die die Aufladung des Kondensators bewirkende Konstantstromquelle unterstützenden und auf ein einstellbares Potential dieses Kondensatoranschlusses kurzzeitig ansprechenden — Stromquelle verbunden ist und dass die Konstantstromquellen derart aufeinander abgestimmt sind, dass sich der der Aufladung des Kondensators dienende Strom $I_1$, zu dem der Entladung dienenden Strom $I_2$ und dem von der dritten Stromquelle gelieferten Strom $I_3$ entsprechend $I_3 > I_2 > I_1$, (1) verhält.

Eine solche Vorrichtung arbeitet in dem Sinn, dass die Entladung des Kondensators unter den gewünschten Schwellwert der Kondensatorspannung weitgehend verhindert wird.

Es ist nun vorteilhaft, wenn zudem die Pulsbreite der Rechteckspannung bei kleinen Tastverhältnissen zusätzlich korrigiert, d.h. beschnitten wird.

Hierzu wird in Weiterbildung der Erfindung vorgeschlagen, dass der Ausgang des Schmitt-Triggers über ein Entkopplungsglied an den Signalausgang des Generators gelegt ist und dass der durch die beiden Konstantstromquellen beaufschlagte Kondensatoranschluss durch einen dreipoligen Halbleiterschalter an den Eingang eines ersten Inverters und dessen Ausgang über einen zweiten Inverter an den Signalausgang des Generators gelegt sind.

Hinsichtlich der weiteren Ausgestaltung sowie weiterer Einzelheiten der Erfindung wird auf die Fig. 1 bis 7 hingewiesen. In Fig. 1 ist das Verhalten der bekannten Rechteckimpulsgeneratoren im Diagramm bei niedrigen Frequenzen und in Fig. 2 bei höheren Frequenzen dargestellt. Fig. 3 zeigt ein vorteilhaftes Ausführungsbeispiel der Erfindung im Schaltbild, während Fig. 4 und Fig. 5 das Verhalten dieser Anordnung bei hohen Frequenzen zeigt. Schliesslich ist in Fig. 6 eine Ergänzungsschaltung gezeigt, mit deren Hilfe man ein Überschreiten des oberen Schwellwertes der Kondensatorspannung in ähnlicher Weise wie ein Unterschreiten verhinden kann, während Fig. 7 eine andere Ausgestaltung einer Anordnung gemäss der Erfindung zeigt.

Für die zuletzt genannte Ausgestaltung benötigt man eine vierte Stromquelle, welche einen durch eine Hilfsspannung $U_{H_2}$ gesteuerten Schwellwertschalter darstellt und die den Entladestrom $I_2$ unterstützt. Der durch diese vierte Stromquelle gelieferte Strom $I_4$ wird so eingestellt, dass er der Bedingung

$$I_4 > I_1 \qquad (2)$$

genügt.

Fig. 1 zeigt die Sägezahnspannung $U_C$ an einem Kondensator C und die davon abgeleitete Rechteckspannung $U_A$, wie man sie bei tiefen Frequenzen mittels eines Rechteckimpulsgenerators der eingangs definierten Art erhält. Die Spannung $U_1$ und $U_2$ bezeichnen den oberen bzw. unteren Schwellwert von $U_C$. Die Laufzeit $\tau$ ist die Verzögerung zwischen dem Erkennen eines Schwellwertes und der Reaktion der Spannung $U_A$. Das Verhältnis $t_2/t_1$ bestimmt das Tastverhältnis. Die Pulsbreite von $U_A$ entspricht der Entladezeit des Kondensators C zwischen $U_1$ und $U_2$. Dabei gilt:
Frequenz $F = (t_1 + t_2)^{-1} = f(U_1, U_2, C)$
Pulsbreite $t_2 = t_{ab}$.

Das Bild verschiebt sich, wie aus Fig. 2 ersichtlich, wenn man zum Betrieb der bekannten Anlagen bei höheren Frequenzen übergeht. Dabei gilt:
Frequenz $F = (t_1 + t_2)^{-1} =$
$\qquad f(U'_1, U'_2, U_1, U_2, C) < f(U_1, U_2, C)$
und für die Pulsbreite $t_2$

$$t_2 = f(\tau, , t_{ab}, U'_1) \approx t_{ab} + \tau$$

$(U'_1 - U_1) \ll (U_2 - U'_2)$ (bei kleinem Tastverhältnis), wobei die Bedeutung der einzelnen Zeiten und Spannungen in der Figur eingezeichnet ist. Wegen der Laufzeit $\tau$ setzt die Entladephase zu spät ein. Deshalb steigt $U_C$, also die Kondensatorspannung, über $U_1$ auf $U'_1$ an. Entsprechend wird

die Entladephase zu spät beendet, d.h. $U_C$ sinkt über $U_2$ auf $U'_2$ ab.

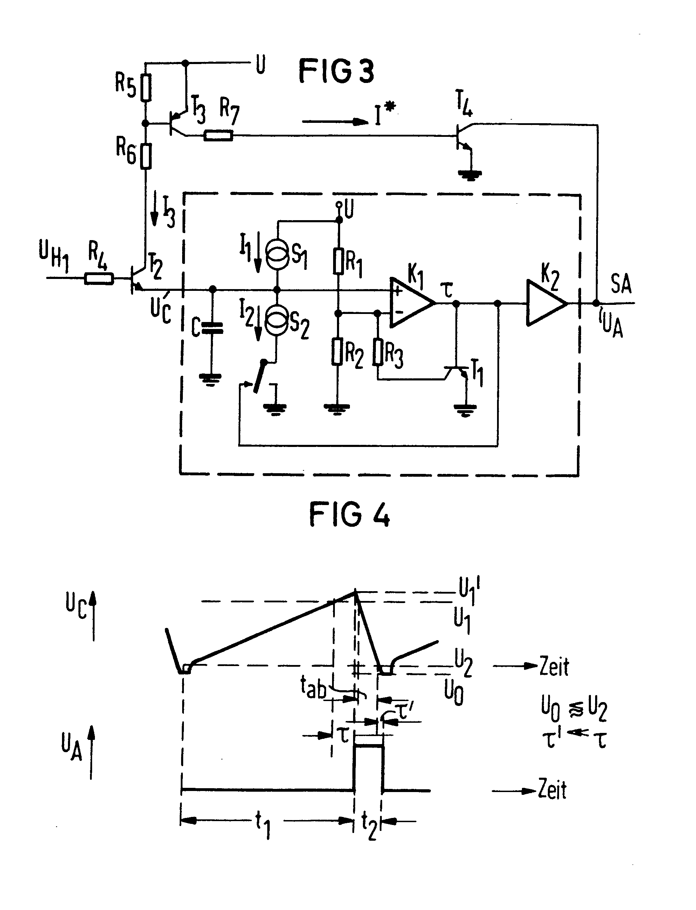

Die bevorzugte Ausgestaltung einer Vorrichtung gemäss der Erfindung ist in Fig. 3 dargestellt, auf die nun Bezug genommen wird. Der umrandete Teil entspricht der bekannten Ausgestaltung mit Ausnahme des Entkopplungsgliedes $K_2$.

Der die Charakteristik des Rechteckimpulsgenerators festlegende Kondensator C liegt mit einem Anschluss am Bezugspotential, also an Masse, während sein anderer Anschluss die Beaufschlagungsstelle der beiden Konstantstromquellen $S_1$ und $S_2$ bildet, die in üblicher Weise ausgestaltet sind und von denen die Stromquelle $S_1$ den Aufladestrom $I_1$ und die Stromquelle $I_2$ den Entladestrom $I_2$ liefert. Der durch die beiden Stromquellen $S_1$ und $S_2$ beaufschlagte Anschluss des Kondensators C ist ausserdem mit dem nichtinvertierenden Eingang eines Operationsverstärkers $K_1$ und ausserdem mit dem Emitter eines den dreipoligen Schalter darstellenden, durch eine Hilfsspannung $U_{H_1}$ gesteuerten Bipolartransistors $T_2$ verbunden.

Der invertierende Eingang des Operationsverstärkers $K_1$ wird durch einen von den beiden Widerständen $R_1$ und $R_2$ gebildeten Spannungsteiler an ein Betriebspotential U gelegt und ist ausserdem über den Widerstand $R_3$ mit dem Kollektor eines weiteren Bipolartransistors $T_1$ verbunden, dessen Emitter am Bezugspotential (Masse) und dessen Basis am Ausgang des Operationsverstärkers $K_1$ liegt, so dass dieser Operationsverstärker $K_1$ zu einem Schmitt-Trigger ergänzt ist. Hierzu gehört auch noch, dass der Ausgang des Schmitt-Triggers über einen, insbesondere durch einen Transistor gegebenen Schalter und über die Stromquelle $S_2$ auf den nichtinvertierenden Eingang des Operationsverstärkers $K_1$ rückkoppelbar ist.

Im Beispielsfalle ist die Stromquelle $S_1$ durch einen pnp-Transistor gegeben, dessen Emitter (vorwiegend über einen Vorwiderstand) am Bezugspotential liegt und dessen Kollektor mit dem Kondensator C und mit dem nichtinvertierenden Eingang des Operationsverstärkers $K_1$ verbunden ist, während die Basis durch ein einstellbares Gleichspannungspotential beaufschlagt ist. Ähnliches gilt für die Konstantstromquelle $S_2$, mit der Ausnahme, dass hier im Beispielsfalle ein npn-Transistor vorgesehen ist. Der den Operationsverstärker $K_1$ zum Schmitt-Trigger ergänzende Transistor $T_1$ ist im Beispielsfalle als npn-Transistor ausgebildet.

Der Erfindung entspricht es nun, dass der Ausgang des Schmitt-Triggers übers ein Entkoppelglied mit dem Signalausgang SA des Rechteckimpulsgenerators verbunden ist. Das Entkoppelglied — im einfachsten Fall ein Transistor (im Beispielsfalle ein npn-Transistor) — ist bei der in Fig. 3 dargestellten Anlage durch einen nicht invertierenden Verstärker $K_2$ gegeben.

Der Erfindung entspricht weiterhin, dass eine weitere Stromquelle über den dreipoligen Schalter $T_2$ an den Kondensator C in dem oben genannten Sinn angeschaltet ist. Der Schalttransistor $T_2$ ist im

Beispielsfall durch einen npn-Transistor gegeben, dessen Basis über einen Vorwiderstand $R_4$ an eine Hilfsspannung $U_{H_1}$ und dessen Kollektor über einen durch die beiden Widerstände $R_5$ und $R_6$ gegebenen Spannungsteiler — und zwar durch die Serienschaltung der beiden Widerstände des Spannungsteilers — an das Betriebspotential U gelegt ist.

Durch einen Bipolartransistor $T_3$ — im Beispielsfalle einen pnp-Transistor — wird der Spannungsteiler zu einem ersten Inverter ergänzt, indem die Basis dieses Transistors mit dem Teilerpunkt zwischen $R_5$ und $R_6$ und der Emitter mit dem am Betriebspotential U liegenden Endpunkt des Spannungsteilers verbunden ist. Der Ausgang des ersten Investers ist durch den Kollektor des Transistors $T_3$ gegeben.

Dieser ist über einen Widerstand $R_7$ an die Basis des den zweiten Inverter darstellenden und im Beispielsfalle durch einen npn-Transistor gegebenen weiteren Bipolartransistors $T_4$ — im Beispielsfalle eines npn-Transistors $T_4$ — gelegt, dessen Emitter am Bezugspotential und dessen Kollektor am Signalausgang SA und damit am Ausgang des Entkopplungsgliedes $K_2$ liegt.

Hinsichtlich der Wirkungsweise ist nun folgendes zu sagen: Der Strom $I_1$ lädt die Kapazität C bis zur Spannung $U_1$ auf und liefert damit die steigende Flanke einer Sägezahnspannung und definiert damit die Pulspause $t_1$. Der Strom $I_2$ dient der Entladung des Kondensators C auf die Spannung $U_2$ und liefert damit die fallende Flanke der Sägezahnspannung und definiert damit die Pulsbreite $t_2$.

Die Umschaltung der Schwellen $U_1 = U \cdot R_2/(R_1 + R_2)$ und

$$U_2 = U \cdot \left(\frac{R_2 \cdot R_3}{R_2 + R_3}\right) / \left(\left(\frac{R_2 \cdot R_3}{R_2 + R_3}\right) + R_1\right)$$

erfolgt durch den als Komparator wirkenden Operationsverstärker $K_1$ und den Transistor $T_1$ mit der Verzögerung $\tau$. Danach beginnt die Entladung des Kondensators C durch das Einschalten des Entladungsstromes $I_2$.

Die Rechteckspannung $U_A$ wird über den Entkoppler $K_2$ ausgekoppelt. Die Verbesserung des Funktionsgenerators gemäss der Erfindung bewirken vor allem die Transistoren $T_2$, $T_3$ und $T_4$ sowie die Widerstände $R_5$, $R_6$ und $R_7$ in Verbindung mit dem Versorgungspotential U und der Hilfsspannung $U_{H_1}$.

Der günstigste Wert der Hilfsspannung $U_{H_1}$ liegt z.B. für $U_2 = 2V$ bei

$$U_{H_1} \approx 0{,}7V + 0{,}9U_2 \approx 0{,}7V$$

$$+ 0{,}9U \cdot \left(\frac{R_2 \cdot R_3}{R_2 + R_3}\right) / \left(\left(\frac{R_2 \cdot R_3}{R_2 + R_3}\right) + R_1\right) \quad (3)$$

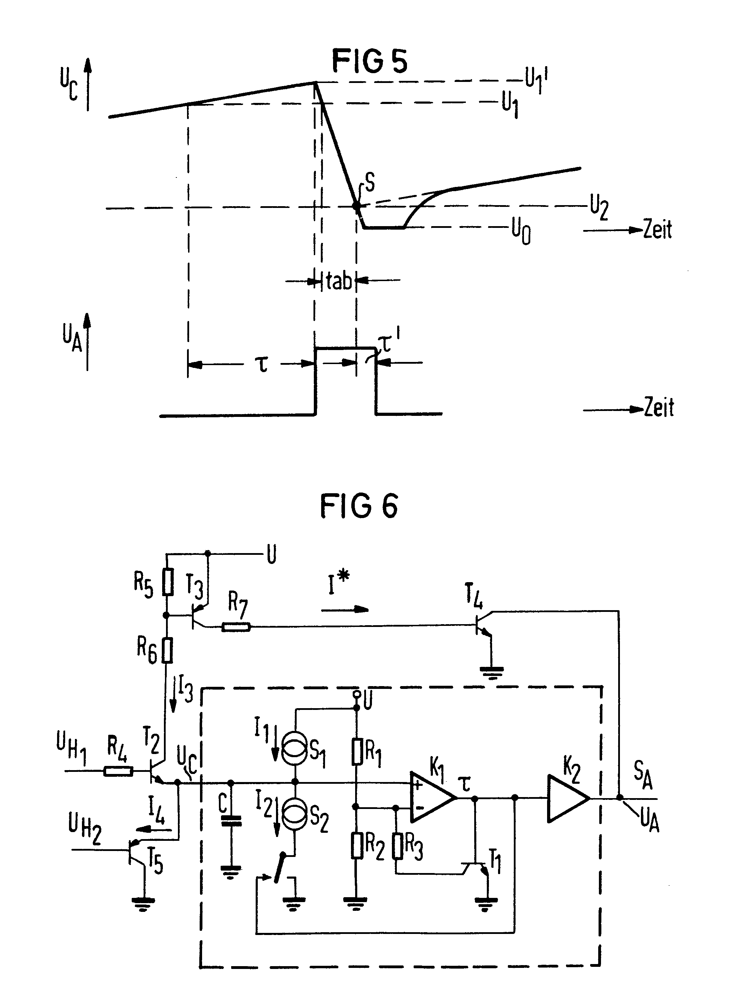

Dann schneidet, wie aus der einen vergrösserten Ausschnitt von Fig. 4 zeigenden Fig. 5 ersichtlich ist, die Tangente an den linearen Teil des Anstiegs von $U_C$ die fallende Flanke von $U_C$ in einem weiteren Frequenzbereich in der Nähe des Schwellwerts $U_2$ (Schnittpunkt S). Die Frequenz wird damit von der Entladung des Kondensators C unter den

Schwellwert $U_2$ auf die Spannung $U_0$ nur wenig beeinflusst.

Sobald die Spannung $U_C$ unter die Schaltschwelle $U_2$ auf den Wert der Hilfsspannung $U_{H_1}$ abzüglich der Basisemitter-Schwellspannung des Schalttransistors $T_2$ abgesunken ist, wird neben der laufenden Entladung des Kondensators C durch den Strom $I_2$ eine Aufladung des Kondensators C durch den Strom $I_3$ bewirkt, wozu, wie bereits angegeben, $I_3 > I_2$ sein muss. Dadurch wird die Entladung des Kondensators C auf die Spannung $U_0$ begrenzt (vgl. Fig. 4 im Vergleich zu Fig. 1 und 2). Der Strom $I_3$, der durch die Widerstände $R_5$ und $R_6$ eingestellt wird, schaltet den Transistor $T_3$ und damit über den Widerstand $R_7$ auch den Transistor $T_4$ nach der Verzögerungszeit durch. Somit wird der Spannungssprung von $U_A$ von dem hohen auf den niedrigen Pegel zeitlich vor dem Durchschalten des Entkopplers $K_2$ auf niedrige Ausgangsspannung bewirkt.

Die Stromaufnahme des Generators wird durch die von der Erfindung vorgeschlagene Ergänzung im Vergleich zu der bekannten Ausgestaltung praktisch nicht erhöht, weil die die Ergänzung bildenden Schaltungsteile nur bei höheren Frequenzen wirksam werden und die Ströme $I_3$ und $I_1$ dann nur kurzdauernde Stromimpulse sind.

Die durch eine der Erfindung genügende Anlage gewährleistete Verhinderung einer Entladung des Kondensators bis einen wesentlich unter dem gewünschten Schwellwert liegenden Bereich und zusätzliche Beschneidung der Pulsbreite der Rechteckspannung bei kleinen Tastverhältnissen erhöht somit bei Funktionsgeneratoren die obere Grenzfrequenz ohne wesentlichen zusätzlichen Aufwand an Schaltungsmitteln im Vergleich zu dem bekannten Rechteckimpulsgenerator. So konnte z.B. eine unterhalb von 25 kHz liegende untere Grenzfrequenz einer ohne die von der Erfindung vorgeschlagenen Ergänzungen aufgebauten Anlage durch Einfügung der genannten Ergänzungen auf über 100 kHz gesteigert werden.

Die anhand der Fig. 3 gezeigte Ausgestaltung eines der Erfindung entsprechenden Rechteckimpulsgenerators zeichnet sich durch ihre Einfachheit aus. Man kann, z.B. durch eine andere Ausgestaltung der beiden Inverter oder des Entkopplers, zu komplizierteren Möglichkeiten gelangen, die jedoch gegenüber dem bereits dargestellten Ausführungsbeispiel höchstens noch geringe Vorteile bringen, so dass sich ein Eingehen auf diese Möglichkeiten erübrigt.

Die bereits oben erwähnte und durch Zuschaltung einer vierten Stromquelle auf den Kondensator C realisierbare Möglichkeit einer weiteren Verbesserung der Erfindung entspricht im Prinzip im wesentlichen der bereits angegebenen Ergänzung. Im einzelnen ist dazu festzustellen, dass nach Überschreiten des oberen Schwellwertes $U_1$ der Kondensatorspannung der durch die Hilfsspannung $U_{H_2}$ gesteuerte Schwellwertschalter — bestehend aus dem Transistor $T_5$ — den Strom $I_4$ einschaltet und somit eine weitere Aufladung des Kondensators C verhindert.

Die Schaltung entspricht der Fig. 3, zugüglich

des pnp-Transistors $T_5$, dessen Emitter mit dem durch die Konstantstromquellen beaufschlagten und mit dem Emitter des npn-Transistors $T_2$ sowie mit dem nicht invertierenden Eingang des Operationsverstärkers $K_1$ verbundenen Anschluss des Kondensators C verbunden ist, während der Kollektor des Transistors $T_2$ am Bezugspotential (Masse) und seine Basis an der Hilfsspannung $U_{H_2}$ liegt.

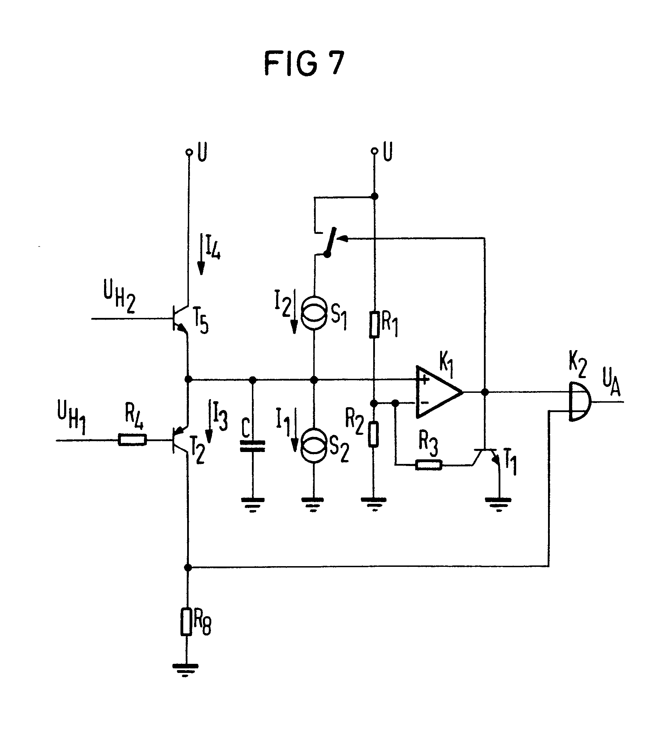

Bei den bisher beschriebenen Ausgestaltungen der Erfindung ist das Tastverhältnis, also das Verhältnis $t_2/t_1$, kleiner als 1. Ist das Tastverhältnis grösser als 1, so wird zweckmässig die aus Fig. 7 ersichtliche Abwandung der in Fig. 3 bzw. Fig. 6 gezeigten Schaltung verwendet.

Bei dieser Ausgestaltung entspricht der durch den Operationsverstärker $K_1$ und dem Transistor $T_1$ bestehende Schmitt-Trigger der Ausgestaltung gemäss Fig. 3. Dasselbe gilt für die Anschaltung des Kondensators C. Da jedoch im vorliegenden Falle — im Gegensatz zu einer Vorrichtung gemäss Fig. 3 — der Ladestrom (und nicht wie bei Fig. 3 der Entladestrom) geschaltet wird, ist die Rolle der die Ströme $I_1$ und $I_2$ liefernden Konstantstromquellen vertauscht. Dies bedeutet, dass der zu schaltende Strom $I_2$ im vorliegenden Fall als Ladestrom und der nicht zu schaltende Strom $I_1$ als Entladestrom dient.

Schaltungsmässig ist ausserdem festzustellen, dass der durch die Hilfsspannung $U_{H_1}$ an seiner Basis zu steuernde Bipolartransistor $T_2$ hier vom pnp-Typ ist und mit seinem Emitter an dem besagten Anschluss des Kondensators C und mit seinem Kollektor über einen Widerstand $R_8$ am Bezugspotential (Masse) liegt, während die Hilfsspannung $U_{H_1}$ an die Basis dieses Transistors $T_2$ über einen Vorwiderstand $R_4$ gelegt ist.

Ferner ist der Schaltungsausgang durch ein ODER-Gatter $K_2$ gegeben, dessen einer Eingang durch den Ausgang des Schmitt-Triggers und dessen zweiter Eingang durch den Kollektor des Schalttransistors $T_2$ beaufschlagt ist. Der Transistor $T_2$ liefert den Strom $I_3$.

Ein durch die Hilfsspannung $U_{H_2}$ an seiner Basis zu steuernder npn-Transistor $T_5$ liegt mit seinem Kollektor am Betriebspotential U und mit seine Emitter an dem Anschluss des Kondensators C, der auch mit dem nicht invertierenden Eingang des Operationsverstärkers $K_1$ und mit dem Emitter des Transistors $T_2$ verbunden ist. Dieser Transistor $T_5$ führt den Strom $I_4$.

Die Schaltung ist so auszulegen, dass die Bedingungen $I_3 > I_2 > I_1$ und $I_4 > I_1$ erfüllt sind.

Der Grund für den Ersatz des Verstärkers $K_2$ durch ein ODER-Gatter $K_2$ ist darin zu sehen, dass bei der Anordnung gemäss Fig. 3 die Signalausgangsspannung $U_A$ vom Pegel HIGH auf den Pegel LOW zu bringen ist, während bei der Anordnung gemäss Fig. 7 gerade das Umgekehrte beabsichtigt ist.

**Patentansprüche**

1. Monolithisch integrierbarer Rechteckimpulsgenerator mit einem durch zwei — einander

entgegengesetzt wirkenden — Konstantstromquellen ($S_1, S_2$) beaufschlagten Kondensator (C), dessen einer Anschluss mit den beiden Konstantstromquellen und ausserdem mit dem nichtinvertierenden Eingang eines als Schmitt-Trigger geschalteten Operationsverstärkers ($K_1$) verbunden ist und dessen anderer Anschluss am Bezugspotential liegt, dadurch gekennzeichnet, dass der durch die beiden Konstantstromquellen ($S_1$, $S_2$) beaufschlagte Anschluss des Kondensators (C) mit einer weiteren — die die Aufladung des Kondensators (C) bewirkende Konstantstromquelle ($S_1$) unterstützenden und auf ein einstellbares Potential dieses Kondensatoranschlusses kurzzeitig ansprechenden — Stromquelle verbunden ist und dass die Konstantstromquellen ($S_1, S_2$) derart aufeinander abgestimmt sind, dass sich der der Aufladung des Kondensators (C) dienende Strom $I_1$ zu dem der Entladung dienenden Strom $I_2$ und dem von der dritten Stromquelle gelieferten Strom $I_3$ entsprechend $I_3 > I_2 > I_1$ verhält.

2. Vorrichtung nach Anspruch 1, dadurch gekennzeichnet, der Ausgang des Schmitt-Triggers über ein Entkopplungsglied ($K_2$) an dem Signalausgang (SA) des Generators gelegt ist und dass als dritte Konstantstromquelle zwei hintereinander geschaltete und durch das gemeinsame Betriebspotential (U) und das Bezugspotential (Masse) beaufschlagte Inverter vorgesehen sind, indem der durch die beiden Konstantstromquellen ($S_1$, $S_2$) beaufschlagte Anschluss des Kondensators (C) durch einen dreipoligen Halbleiterschalter ($T_2$) an den Eingang des ersten Inverters und dessen Ausgang über einen zweiten Inverter an den Signalausgang des Generators (SA) gelegt sind.

3. Vorrichtung nach Anspruch 2, dadurch gekennzeichnet, dass der dreipolige Schalter durch einen Bipolartransistor ($T_2$) gegeben ist, dessen Basis — insbesondere über einen Vorwiderstand ($R_4$) — durch eine Hilfsspannung ($U_{H_1}$) beaufschlagt ist, dessen Emitter mit dem durch die dritte Stromquelle zu beaufschlagenden Anschluss des Kondensators (C) und dem nichtinvertierenden Eingang des Operationsverstärkers ($K_1$) verbunden ist und dessen Kollektor durch die beiden Inverter beaufschlagt ist.

4. Vorrichtung nach einem der beiden Ansprüche 3 oder 4, dadurch gekennzeichnet, dass der eine Anschluss des dreipoligen Schalters, insbesondere der Kollektor eines Bipolartransistors ($T_2$), über einen Widerstand ($R_6$) an einen Schaltungsknoten gelegt ist, dass dieser Schaltungsknoten über einen Widerstand ($R_5$) und der zu diesem Widerstand ($R_5$) parallel liegenden Emitterbasisstrecke eines Bipolartransistors ($T_3$) an das Betriebspotential (U) gelegt ist, dass der Kollektor dieses Bipolartransistors ($T_3$) über einen Widerstand ($R_7$) mit der Basis eines weiteren Transistors ($T_4$) verbunden ist, dass der Ermitter dieses weiteren Transistors ($T_4$) am Bezugspotential (Masse) liegt und dass der Kollektor dieses weiteren Transistors mit dem Signalausgang (SA) des Generators verbunden ist.

5. Vorrichtung nach Anspruch 4, dadurch gekennzeichnet, dass ein den Operationsverstärker ($K_1$) zum Schmitt-Trigger ergänzender und zwischen dessen invertierendem Eingang und dessen Ausgang liegender Bipolartransistor ($T_1$) sowie der den dreipoligen Schalter darstellende Transistor ($T_2$) und der den zweiten Inverter bildende Transistor ($T_4$) vom npn-Typ und der Transistor ($T_3$) des ersten Inverters vom pnp-Typ ist.

6. Vorrichtung nach den Ansprüchen 3 bis 5, dadurch gekennzeichnet, dass der Emitter des den dreipoligen Schalter bildenden Bipolartransistors ($T_2$) mit dem Emitter eines zu ihm komplementären Bipolartransistors ($T_5$) verbunden und die Basis dieses komplementären Bipolartransistors ($T_5$) durch eine Hilfsspannung ($U_{H_2}$) und sein Kollektor durch das Bezugspotential (Masse) beaufschlagt ist.

7. Vorrichtung nach den Ansprüchen 1 bis 6, dadurch gekennzeichnet, dass ein als dreipoliger Schalter dienender und an seiner Basis mit einer Hilfsspannung ($U_{H_1}$) zu beaufschlagender Bipolartransistor ($T_2$) mit seinem Kollektor — ggf. über einen Vorwiderstand ($R_8$) — am Bezugspotential (Masse) und mit seinem Emitter sowohl an dem mit dem Lade- und Entladestrom ($I_1, I_2$) zu beaufschlagenden Anschluss des Kondensators (C) als auch am Emitter eines zu ihm komplementären weiteren Bipolartransistors ($T_5$) liegt, dass der Kollektor dieses weiteren Bipolartransistors ($T_5$) am Betriebspotential (U) und seine Basis an einer weiteren Hilfspannung ($U_{H_2}$) liegt, dass ferner der Kollektor des den dreipoligen Schalter bildenden Bipolartransistors ($T_2$) an den einen Eingang und der Ausgang des Schmitt-Triggers ($K_1, T_1$) an den anderen Eingang eines den Signalausgang des Impulsgenerators bildenden ODER-Gatters ($K_2$) geschaltet ist, und dass schliesslich die Bestandteile des Impulsgenerators so dimensioniert sind, dass die von den beiden Konstantstromquellen an den Kondensator (C) gelieferten Ströme, nämlich der für diesen Fall zu schaltende Ladestrom ($I_2$) und der für diesen Fall nicht zu schaltende Entladestrom ($I_1$), sowie der über den als dreipoligen Schalter dienenden Bipolartransistor ($T_2$) zugeführte Strom ($I_3$) sowie der über den hierzu komplementären Transistor ($T_5$) geführte Strom ($I_4$) sich so verhalten, dass $I_3 > I_2 > I_1$ und $I_4 > I_1$ gilt.

**Claims**

1. A monolithically integratable rectangular pulse generator comprising a capacitor (C) which is fed by two constant current sources ($S_1$, $S_2$) which operate in mutually opposed fashion, and whose first terminal is connected to the two constant current sources and to the non-inverting input of an operational amplifier ($K_1$) connected as a Schmitt trigger stage, and whose other terminal is connected to a reference potential point, characterized in that the terminal of the capacitor (C) which is supplied by the two constant current sources ($S_1$, $S_2$) is also connected to a further current source whose function is to support the constant current source ($S_1$) which serves to charge the capacitor (C) and which temporarily responds to an adjustable potential of this capacitor terminal, and that the output of the Schmitt trigger stage is connected via a decoupling element ($K_2$) to the signal output (SA) of the generator and that the constant current sources ($S_1$, $S_2$) are tuned to one another in such manner that the ratio of the current $I_1$ which serves for charging the capacitor (C) to the current $I_2$ which serves for discharging, and to the current $I_3$ supplied by the third current source is in the order of $I_3 > I_2 > I_1$.

2. A device as claimed in claim 1, characterized in that the third constant current source consists of two inverters connected in series and supplied from the common operating potential (U) and the reference potential (earth), the terminal of the capacitor (C) fed by the two constant current sources ($S_1$, $S_2$) being connected by a three-pole semiconductor switch ($T_2$) to the input of the first inverter, and the output of same is connected via a second inverter to the signal output of the generator (SA).

3. A device as claimed in claim 2, characterized in that the three-pole switch consists of a bipolar transistor ($T_2$) whose base is supplied — in particular via a series resistor ($R_4$) — from an auxiliary voltage ($U_{H_1}$), whose emitter is connected both to that terminal of the capacitor (C) which is to be fed by the third current source and to the non-inverting input of the operational amplifier ($K_1$), and whose collector is fed by the two inverters.

4. A device as claimed in claim 3 or 4, characterized in that the first terminal of the three-pole switch, in particular the collector of a bipolar transistor ($T_2$) in connected via a resistor ($R_6$) to a circuit node, said circuit node is connected via the parallel combination of a resistor ($R_5$) and the emitter-base path of a bipolar transistor ($T_3$) to the operating potential (U), that the collector of this bipolar transistor ($T_3$) is connected via a resistor ($R_7$) to the base of a further transistor ($T_4$), that the emitter of this further transistor ($T_4$) is connected to the reference potential (earth), and that the collector of this further transistor is connected to the signal output (SA) of the generator.

5. A device as claimed in claim 4, characterized in that a bipolar transistor ($T_1$) which supplements the operational amplifier ($K_1$) to form the Schmitt trigger stage and which is located between the output and the inverting input thereof, and the transistor ($T_2$) which represents the three-pole switch, and the transistor ($T_4$) which forms the second inverter are all of the npn-type, whereas the transistor ($T_3$) of the first inverter is of the pnp-type.

6. A device as claimed in the claims 3 to 5, characterized in that the emitter of the bipolar transistor ($T_2$) which forms the three-pole switch is connected to the emitter of the bipolar transistor ($T_5$) which is complementary thereto, and the base of this complementary bipolar transistor ($T_5$) is supplied with an auxiliary voltage ($U_{H_2}$), whereas its collector is supplied by the reference potential (earth).

7. A device as claimed in the claims 1 to 6, characterized in that a bipolar transistor ($T_2$) which serves as a three-pole switch and whose base is to be supplied with an auxiliary voltage ($U_{H_1}$) is connected by its collector — possibly via a series resistor ($R_8$) — to the reference potential (earth), and by its emitter both to that terminal of the capacitor (C) which is to be fed with the charging and discharging current ($I_1$, $I_2$) and also to the emitter of a further bipolar transistor ($T_5$) which is complementary thereto, that the collector of this further bipolar transistor ($T_5$) is connected to the operating potential (U), and its base is connected to a further auxiliary voltage ($U_{H_2}$), that moreover the collector of the bipolar transistor ($T_2$) which forms the three-pole switch is connected to the first input of an OR-gate ($K_2$) which forms the signal output of the pulse generator, whereas the output of the Schmitt trigger ($K_1$, $T_1$) is connected to the other input of said OR-gate, and that finally the components of the pulse generator are dimensioned in such manner that the currents which are supplied by the two constant current sources to the capacitor (C), namely the charging current ($I_2$) which is to be connected in this case and the discharging current ($I_1$) which is not to be connected in this case, and also the current ($I_3$) which is fed via the bipolar transistor ($T_2$) which serves as three-pole switch, and the current ($I_4$) which flows through the transistor ($T_5$) which is complementary thereto, are all interrelated in such manner that $I_3 > I_2 > I_1$ and $I_4 > I_1$.

**Revendications**

1. Générateur d'impulsions rectangulaires monolithique intégrable, comportant un condensateur (C) chargé par deux sources de courant constant agissant en sens opposé l'une de l'autre, et dont l'une des bornes est reliée à l'une des deux sources de courant constant ainsi qu'à l'entrée non inverseuse d'un amplificateur opérationnel en montage à bascule de Schmitt, alors que l'autre borne est au potentiel de référence, caractérisé par le fait que la borne du condensateur (C) qui est chargée par les deux sources de courant constant ($S_1$, $S_2$) est reliée à une source supplémentaire de courant constant, qui assiste la charge du condensateur (C) par la source de courant constant ($S_1$) et qui répond rapidement à un potentiel réglable de cette borne de condensateur, et par le fait que les sources de courant constant ($S_1$, $S_2$) sont ajustées de telle façon l'une par rapport à l'autre que le courant ($I_1$) qui sert à charger le condensateur ($C_1$), le courant ($I_2$) qui sert à la décharge et le courant ($I_3$) qui est fourni par la troisième source de courant satisfont à la relation $I_3 > I_2 > I_1$.

2. Dispositif selon la revendication 1, caractérisé par le fait que la sortie de la bascule de Schmitt est reliée, par l'intermédiaire d'un organe de découplage ($K_2$), à la sortie des signaux (SA) du générateur, et par le fait que la troisième source de courant constant est constituée par deux inverseurs montés l'un derrière l'autre, chargés par le potentiel de service commun (U) et par le potentiel de référence (masse), la borne du condensateur (C) qui est chargée par les deux sources de courant constant ($S_1$, $S_2$) étant reliée par un commutateur tripolaire à semiconducteurs ($T_2$) à l'entrée du premier inverseur, alors que sa sortie est reliée par l'intermédiaire d'un second inverseur à la sortie des signaux du générateur (A).

3. Dispositif selon la revendication 2, caractérisé par le fait que le commutateur tripolaire est constitué par un transistor bipolaire ($T_2$) dont la base est chargée, en particulier par l'intermédiaire d'une résistance de chute ($R_4$), par une tension auxiliaire ($U_{H_1}$), dont l'émetteur est relié à la borne du condensateur (C), qui est chargée par la troisième source de courant, et à l'entrée non inverseuse de l'amplificateur opérationnel ($K_1$), et dont le collecteur est chargé par les deux inverseurs.

4. Dispositif selon l'une des revendications 3 ou 4, caractérisé par le fait que l'une des bornes du commutateur tripolaire, particulièrement le collecteur d'un transistor bipolaire ($T_2$), est reliée par l'intermédiaire d'une résistance ($R_6$) à un point du circuit, par le fait que ce point du circuit est relié par l'intermédiaire d'une résistance ($R_5$) et par le circuit émetteur-base — en parallèle à cette résistance ($R_5$) — d'un transistor bipolaire ($T_3$) au potentiel de service (U), par le fait que le collecteur de ce transistor bipolaire ($T_3$) est relié par l'intermédiaire d'une résistance ($R_7$) à la base d'un autre transistor ($T_4$), par le fait que l'émetteur dudit autre transistor ($T_4$) est au potentiel de référence (masse) et que le collecteur dudit autre transistor est relié à la sortie des signaux (SA) du générateur.

5. Dispositif selon la revendication 4, caractérisé par le fait qu'un transistor bipolaire ($T_1$), qui complète l'amplificateur opérationnel ($K_1$) en une bascule de Schmitt et qui est situé entre l'entrée inverseuse et la sortie dudit amplificateur opérationnel, de même que le transistor ($T_2$), représentant le commutateur tripolaire et le transistor ($T_4$) qui constitue le second inverseur, sont du type npn et le transistor ($T_3$) du premier inverseur est du type pnp.

6. Dispositif selon les revendications 3 à 5, caractérisé par le fait que l'émetteur du transistor bipolaire ($T_2$) qui constitue le commutateur tripolaire est relié à l'émetteur d'un transistor bipolaire ($T_5$) qui lui est complémentaire, et la base de ce transistor bipolaire complémentaire ($T_5$) est chargée par une tension auxiliaire ($U_{H_2}$) et son collecteur est chargé par la tension de référence (masse).

7. Dispositif selon les revendications 1 à 6, caractérisé par le fait qu'un transistor bipolaire ($T_2$), qui sert de commutateur tripolaire et dont la base est à attaquer par une tension auxiliaire ($U_{H_1}$), a son collecteur, éventuellement par l'intermédiaire d'une résistance de chute ($R_8$), relié à la borne du condensateur (C), qui est à charger avec le courant de charge et de décharge ($I_1$, $I_2$), ainsi qu'à un émetteur d'un transistor bipolaire supplémentaire ($T_5$) qui lui est complémentaire, par le fait que le collecteur de ce transistor bipolaire supplémentaire ($T_5$) est relié au potentiel de service (U) et que sa base est reliée à une tension auxiliaire supplémentaire ($U_{H_2}$), par le fait que, en outre, le collecteur du transistor bipolaire ($T_2$) qui constitue le commutateur tripolaire est relié à une entrée, et la sortie de la bascule de Schmitt ($K_1$, $T_1$) à l'autre entrée d'une porte OU ($K_2$) qui constitue la sortie des signaux du générateur d'impulsions, et qu'enfin les éléments constitutifs du générateur d'impulsions sont dimensionnés de telle façon que les courants fournis par les deux sources de courant constant au condensateur (C), plus particulièrement le courant de charge ($I_2$) qui est à brancher pour ce cas et le courant de décharge ($I_1$) qui n'est pas à brancher pour ce cas, de même que le courant ($I_3$) passant par l'intermédiaire du transistor bipolaire ($T_2$) servant de commutateur tripolaire, ainsi que le courant ($I_4$) passant par le transistor ($T_5$) qui lui est complémentaire, satisfont la relation $I_3 > I_2 > I_1$, et $I_4 > I_1$.

# FIG 1

# FIG 2

## FIG 3

$R_5$ $R_6$ $R_7$ $T_3$ $U$ $I^*$ $T_4$

$U_{H_1}$ $R_4$ $T_2$ $I_3$ $U_C'$ $C$

$I_1$ $S_1$ $I_2$ $S_2$ $U$ $R_1$ $R_2$ $R_3$ $K_1$ $\tau$ $T_1$ $K_2$ $SA$ $U_A$

## FIG 4

$U_C$

$U_1'$
$U_1$
$U_2$
$U_0$
Zeit

$t_{ab}$ $\tau'$ $\tau$

$U_0 \lessapprox U_2$
$\tau' \ll \tau$

$U_A$

Zeit

$t_1$ $t_2$

11

# FIG 5

# FIG 6

# FIG 7